# FASCICULE DE BREVET EUROPEEN

(11) **EP 4 005 029 B1**
(45) Date de publication et mention de la délivrance du brevet: **16.08.2023**
(21) Numéro de dépôt: 20725587.8
(22) Date de dépôt: 19.05.2020
(51) Int. Cl.: H01R 9/24, H01R 107/00, H01R 4/36

(54) **BOITIER DE BORNIER DESTINE À ACCUEILLIR AU MOINS UN CÂBLE MULTIBRINS**
KLEMMENBLOCKGEHÄUSE ZUR AUFNAHME VON MINDESTENS EINEM MEHRSTRANGIGEN KABEL
TERMINAL BLOCK HOUSING INTENDED TO RECEIVE AT LEAST ONE MULTI-STRAND CABLE

(30) Priorité: 24.07.2019 FR 1908406
(43) Date de publication de la demande: 01.06.2022
(73) Titulaire: Sagemcom Energy & Telecom SAS, 92500 Rueil-Malmaison (FR)
(72) Inventeur: ROLLAND, Patrick, 92500 RUEIL MALMAISON (FR)
(74) Mandataire: Lavaud, Thomas
(86) Numéro de dépôt international: PCT/EP2020/063998
(87) Numéro de publication internationale: WO 2021/013404

(56) Documents cités:
- KR-A- 20190 019 458
- US-B1- 7 845 980

## Description

L'invention concerne un boitier comprenant un bornier destiné à accueillir au moins un câble multibrins.

### ARRIERE PLAN DE L'INVENTION

Lors de l'installation de compteurs électriques, des câbles multibrins doivent être raccordés au bornier du compteur. KR20190019458 A divulgue un boitier selon le préambule de la revendication 1.

A cet effet, un opérateur dénude chaque câble sur plusieurs millimètres, usuellement 17 millimètres, avant d'introduire le câble dans le bornier.

Les câbles sont classiquement à 7 brins ou multibrins de très faible diamètre (de 320 brins environ). Dans ce dernier cas, une fois l'extrémité du câble dénudée, il peut arriver que des brins s'en détachent. Or les brins ont un diamètre d'environ un dixième de millimètre et peuvent ainsi facilement se glisser dans des interstices. Dans un compteur dit « à entrée basse », le bornier se trouve en extrémité basse du compteur. Dans ce cas, les brins ne peuvent pénétrer à l'intérieur du compteur car, de par la gravité, les brins restent confinés dans le bornier.

En revanche dans un compteur dit « à entrée haute », le bornier se trouve en extrémité haute du compteur. Dès lors des brins peuvent ainsi pénétrer par gravité à l'intérieur du compteur par des interstices entre le bornier et le reste du compteur électrique et atteindre des zones sensibles comme des cartes électroniques. Ceci peut entraîner un court-circuit lors de l'utilisation du compteur électrique.

Malheureusement cette intrusion des brins se fait à l'insu de l'opérateur du fait du faible diamètre des brins et de l'impossibilité de visualiser cette partie du compteur: l'opérateur ne peut donc pas intervenir pour prévenir cet accident.

Pour éviter ce problème, il a été envisagé d'avoir recours à un système de chicanes solidaires du socle et/ou du capot du compteur.

Malheureusement une telle solution est volumineuse et l'environnement du compteur ne permet pas toujours l'implantation de chicanes.

### OBJET DE L'INVENTION

Un but de l'invention est de proposer un boîtier limitant un risque de pénétration de brins métalliques issu d'une extrémité dénudée d'un câble destinée à être raccordée au boitier.

### RESUME DE L'INVENTION

En vue de la réalisation de ce but, on propose, selon l'invention, un boitier comprenant un bornier destiné à accueillir au moins une extrémité d'un câble multibrins et comprenant à cet effet au moins un logement de réception de l'extrémité du câble, le logement étant pourvu d'une paroi dans laquelle est ménagée une ouverture à travers laquelle s'étend en service l'extrémité du câble et un flanc agencé à l'opposé de la paroi portant l'ouverture, au moins une face du flanc orientée vers l'intérieur du logement étant pourvue d'aspérités pour limiter un risque de glissement d'au moins un brin détaché de l'extrémité du câble à travers un espace entre le flanc et le reste du boitier.

De la sorte, en ajoutant astucieusement un flanc de texture non lisse au fond du boîtier on limite un risque qu'un brin ne vienne pénétrer à l'intérieur du reste du boitier et n'atteigne des zones sensibles comme par exemple, et de manière non limitative, une ou des cartes électroniques agencées dans le boitier.

En particulier la texture non lisse du flanc limite le déplacement des brins détachés dans le logement et donc limite un risque que les brins n'atteignent un interstice entre le logement et le reste du boitier.

L'invention s'avère en outre simple à mettre en oeuvre et peu volumineuse. En particulier, l'invention n'a pas besoin de recourir à des chicanes volumineuses de l'art antérieur.

Bien entendu pour la présente demande les termes « haut » et « bas » s'étendent selon la position en service du boitier lorsqu'il est fixé à un support. Les termes « droit », « gauche », « avant », « arrière » s'entendent également selon la position en service du boitier lorsqu'il est fixé à un support et qu'on le regarde de face, le support derrière le boitier.

Optionnellement des aspérités de la face sont formées au moins par des stries.

Optionnellement les stries sont juxtaposées sans espace entre deux stries consécutives.

Optionnellement les stries sont toutes identiques sur une même face.

Optionnellement au moins l'une des stries à une section triangulaire.

Optionnellement au moins l'une des stries présente un sommet pointu.

Optionnellement au moins l'une des stries à une hauteur au moins supérieure à 1 millimètre.

Optionnellement des aspérités de la face sont formées au moins par un grainage de la face.

Optionnellement le grainage est tel qu'il forme des criques d'une profondeur comprise entre 3 et 5 centièmes de millimètres sur la face associée.

Optionnellement le boîtier comporte au moins une languette agencée au niveau de l'espace entre le flanc et le reste du boîtier, au moins une face de la languette étant pourvue d'aspérité.

Optionnellement des aspérités de la face sont formées au moins par des stries.

Optionnellement des aspérités de la face sont formées au moins par un grainage de ladite face.

Optionnellement le boîtier est un compteur électrique. D'autres caractéristiques et avantages de l'invention ressortiront à la lecture de la description qui suit d'un mode de mise en oeuvre particulier non limitatif de l'invention.

### BREVE DESCRIPTION DES DESSINS

L'invention sera mieux comprise à la lumière de la description qui suit en référence aux figures annexées parmi lesquelles :
[Fig. 1] la figure 1 est une vue en perspective d'un compteur électrique à entrée basse selon un mode de réalisation particulier de l'invention,
[Fig. 2] la figure 2 est une vue en perspective d'une partie haute d'un socle du compteur électrique illustré à la figure 1,
[Fig. 3] la figure 3 est une vue en coupe partielle d'une partie haute du compteur électrique illustré à la figure 1, le capot du compteur n'étant pas visible,
[Fig. 4] la figure 4 est une vue en perspective similaire à la figure 3 une partie du capot du compteur électrique étant également visible,
[Fig. 5] la figure 5 est une vue en perspective d'un compteur électrique selon une variante de l'invention.

### DESCRIPTION DETAILLEE DE L'INVENTION

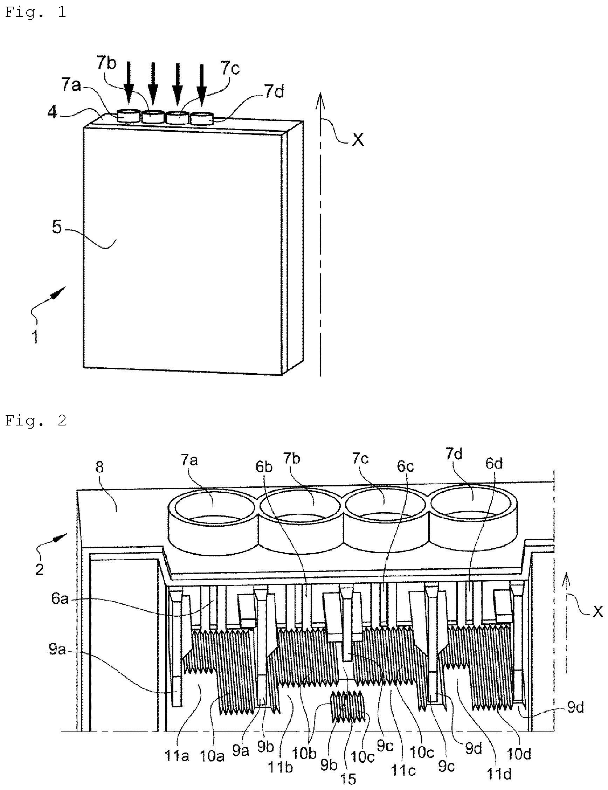

En référence aux figures 1 à 4, un boîtier selon un mode de réalisation particulier de l'invention, généralement désigné en 1, est ici un compteur électrique à entrée haute.

Le boîtier comporte un socle 2 et un capot 3 formant conjointement un corps de boîtier. Le socle 2 est la partie du boîtier 1 destiné à être agencé contre un support, tel qu'un mur, pour fixer le boîtier 1. Le capot 3 est la partie du boîtier 1 ramenée sur le socle 2, lorsqu'il est en place sur le support, pour refermer le boitier 1.

Du fait que le compteur électrique soit à entrée haute, le boitier 1 comporte un bornier 4 agencé dans sa partie haute, le bornier 4 étant ici défini par la coopération entre le socle 2 et le capot 3. Le bornier 4 forme la zone de raccordement du boitier 1, le reste du boitier 1 formant un coffre de travail 5 du boitier 1 et renfermant les éléments sensibles du boitier 1 tels que par exemple une ou des cartes électroniques.

Le bornier 4 présente au moins un logement de réception d'une extrémité d'un câble multibrins, extrémité qui est dénudée au moins sur une partie de sa longueur. L'extrémité du câble est typiquement dénudée sur 17 millimètres. Le câble multibrins est par exemple un câble d'environ320 brins. Chaque brin a un diamètre d'environ 0.1 millimètre. Chaque brin est ici en cuivre.

Selon un mode de réalisation particulier, le bornier 4 comporte quatre logements 6a, 6b, 6c, 6d aptes à recevoir chacun une extrémité dénudée d'un câble multibrins.

Les quatre logements 6a, 6b, 6c, 6d s'étendent ici parallèlement les uns aux autres et à un même axe X. Lorsque le boîtier 1 est en place sur un support, l'axe X s'étend sensiblement verticalement.

Les quatre logements 6a, 6b, 6c, 6d sont par ailleurs juxtaposés.

Les logements comportent notamment chacun une ouverture 7a, 7b, 7c, 7d à travers laquelle l'extrémité du câble associé est introduite. De préférence, les différentes ouvertures 7a, 7b, 7c, 7d sont toutes ménagées dans une même paroi latérale 8 du boîtier 1. Ladite paroi latérale 8 est ici intégrée au socle 2 et agencée de sorte à former une face supérieure du boîtier 1.

De la sorte, les ouvertures 7a, 7b, 7c, 7d sont présentes sur la face supérieure du boîtier 1 et les câbles peuvent être introduits sensiblement à la verticale au niveau de ladite face dans les logements 6a, 6b, 6c, 6d comme cela est illustré par les flèches à la figure 1.

Le compteur est ici un compteur monophasé.

Dès lors un premier logement 6a (correspondant au logement d'extrémité gauche) est destiné à recevoir un câble correspondant à une phase, le deuxième logement 6b (correspondant au logement juxtaposé au premier logement) est destiné à recevoir un câble correspondant au neutre, le troisième logement 6c (correspondant au logement juxtaposé au deuxième logement) est destiné à recevoir un câble correspondant au neutre et le quatrième logement 6d (correspondant au logement juxtaposé au troisième logement et également au logement d'extrémité droite) est destiné à recevoir un câble correspondant à une phase. Le deuxième logement 6b et le troisième logement 6c sont également appelés conjointement logements centraux. Le premier logement 6a et le deuxième logement 6b sont utilisés pour le raccordement au réseau électrique et le troisième logement 6c et le quatrième logement 6d sont utilisés pour le raccordement au domicile d'un utilisateur.

Comme déjà indiqué, les termes gauche et droit doivent être entendus dans la position en service du boîtier 1 c'est-à-dire en plaçant le socle 2 contre un support, les ouvertures 7a, 7b, 7c, 7d étant en alors sur la face supérieure du boîtier 1.

Chaque logement 6a, 6b, 6c, 6d est délimité par le socle 2 et le capot 3, formant l'arrière et l'avant des logements 6a, 6b, 6c, 6d, mais également par la paroi latérale 8 dans laquelle sont ménagées les ouvertures 7a, 7b, 7c, 7d formant le dessus des logements 6a, 6b, 6c, 6d. Par ailleurs chaque logement 6a, 6b, 6c, 6d est également délimité par trois flancs s'étendant à partir du socle 2 en direction du capot 3 sensiblement à la perpendiculaire du socle 2 :
- deux flancs 9a, 9b, 9c, 9d formant des côtés du logement en s'étendant sensiblement à la perpendiculaire de la paroi latérale 8, et
- un flanc 10a, 10b, 10c, 10d formant un fond du logement 6a, 6b, 6c, 6d, en s'étendant face à l'ouverture 7a, 7b, 7c, 7d, sensiblement à la parallèle de la paroi latérale 8, ledit flanc étant appelé par la suite flanc d'isolement.

On note qu'un flanc 9a, 9b, 9c, 9d formant un côté d'un des logements 6a, 6b, 6c, 6d, peut être commun à deux logements juxtaposés.

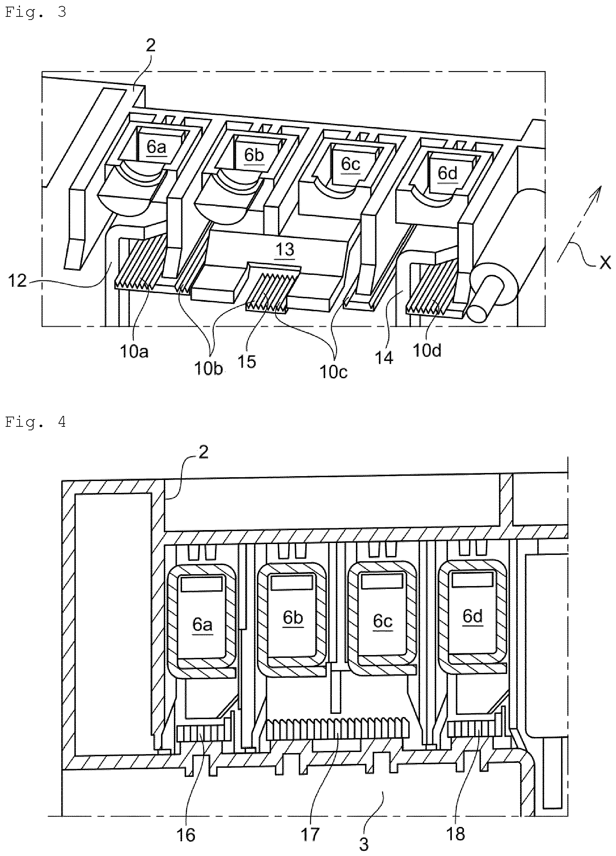

Comme plus visible à la figure 3, pour assurer le bon fonctionnement du boîtier 1, des pattes de connexion en matière électriquement conductrice s'étendent entre le coffre de travail 5 et le bornier 4 en traversant les flancs d'isolement 10a, 10b, 10c, 10d. On comprend donc que les logements 6a, 6b, 6c, 6d ne peuvent former des contenants hermétiques entre le bornier 4 et le coffre de travail 5 du fait d'orifices 11a, 11b, 11c, 11d ménagés dans les flancs d'isolement 10a, 10b, 10c, 10d pour assurer le passage des pattes de connexion.

Les extrémités des câbles s'appuient sur les pattes de connexion et/ou les flancs d'isolement 10a, 10b, 10c, 10d selon que les pattes de connexion comportent ou non un retour s'étendant dans le logement 6a, 6b, 6c, 6d considéré parallèlement au flanc d'isolement associé, 10a, 10b, 10c, 10d.

Les différentes pattes de connexion sont de préférence en cuivre.

Plus précisément ici, le boîtier 1 comporte une patte gauche 12 associée au premier logement 6a, une patte droite 14 associée au quatrième logement 6d et une double patte 13 associée aux logements centraux 6b et 6c.

En conséquence, le premier flanc 10a comporte un orifice 11a ménagé dans sa partie avant gauche pour le passage de la patte gauche 12. Le quatrième flanc 10d comporte un orifice 11d ménagé dans sa partie avant gauche pour le passage de la patte droite 14. Le deuxième flanc 10b comporte un orifice 11b ménagé dans sa partie avant droite et le troisième flanc 10c comporte un orifice 11c ménagé dans sa partie avant gauche pour le passage de la double patte 13. On note qu'avec le jeu des orifices une portion de flancs est commune aux deux flancs centraux 10b, 10c: il s'agit de la portion centrale 15 entourée par l'intérieur de la double patte 13 qui est globalement conformée en U.

Chaque flanc d'isolement 10a, 10b, 10c, 10d est pourvu d'aspérités (la portion centrale 15 comprise) afin de limiter un risque de glissement d'au moins un brin détaché de l'extrémité dénudée du câble associé à travers les orifices 11a, 11b, 11c, 11d d'accès aux logements 6a, 6b, 6c, 6d par les pattes de connexion. On limite en particulier un risque que les brins n'atteignent des zones sensibles du coffre de travail 5 ce qui pourrait entraîner un court-circuit.

Plus précisément ici au moins une face de chaque flanc d'isolement 10a, 10b, 10c, 10d tournée vers l'intérieur du logement associé 6a, 6b, 6c, 6d est pourvue d'aspérités, soit la face faisant face au retour de la patte de connexion associée ou à l'extrémité du câble associée.

Dans le cas présent, seule la face de chaque flanc d'isolement 10a, 10b, 10c, 10d tournée vers l'intérieur du logement 6a, 6b, 6c, 6d d'isolement est pourvue d'aspérités. En variante, au moins une autre face du ou des flancs d'isolement 10a, 10b, 10c, 10d sera également pourvue d'aspérités comme par exemple la ou les faces du flanc d'isolement 10a, 10b, 10c, 10d considéré formant l'orifice 11a, 11b, 11c, 11d à travers laquelle s'étend la patte de connexion associée.

De préférence, la texture non lisse pourvue d'aspérités de chaque flanc d'isolement 10a, 10b, 10c, 10d est assurée au moins par des stries.

De préférence, les faces striées de chaque flanc d'isolement 10a, 10b, 10c, 10d sont conformées de sorte que les stries en recouvrent toute la surface de manière régulièrement réparties. De préférence, les stries d'une même face striée sont juxtaposées de manière qu'il n'y a pas de zones planes entre deux stries consécutives : à un creux d'une strie succède immédiatement un sommet d'une autre.

Les stries présentent ici une section en triangle. Chaque face striée présente donc une section en dents de scie. Par ailleurs les stries sont conformées de manière que le sommet libre de chaque strie forme un angle aigu et donc non arrondi.

On facilite ainsi le glissement des brins dans le creux des stries.

Les stries sont telles que la hauteur entre le sommet libre de chaque strie et la base de la strie associée soit au moins de 0.5 millimètre de hauteur et préférentiellement encore au moins de 0.8 millimètre de hauteur et préférentiellement encore au moins de 1 millimètre de hauteur.

Les stries présentent plus précisément ici une section en triangle isocèle ou équilatéral.

Selon un mode de réalisation préféré, les stries sont conformées pour s'étendre entre le capot 3 et le socle 2 et par ailleurs sensiblement orthogonalement au capot 3 et au socle 2.

Ceci limite un déplacement des brins de droite à gauche (ou inversement) dans les logements 6a, 6b, 6c, 6d et donc un déplacement vers les orifices 11a, 11b, 11c, 11d permettant d'accéder au coffre de travail. Préférentiellement, la texture non lisse pourvue d'aspérités de chaque flanc d'isolement 10a, 10b, 10c, 10d est également assurée ici par un grainage desdits flancs.

Le grainage recouvre ici de manière continue toute la surface des faces texturées de chaque flanc d'isolement 10a, 10b, 10c : le grainage est donc apposé ici sur chacune des stries et ce sur chaque flanc d'isolement 10a, 10b, 10c, 10d.

De la sorte, on augmente les propriétés d'anti-glissement des flancs d'isolement 10a, 10b, 10c, 10d.

Le grainage des faces pourvues d'aspérités est par exemple tel que lesdites faces comportent des criques d'une profondeur comprise entre 3 et 5 centièmes de millimètres.

Le grainage et le striage des faces pourvues d'aspérités peut se faire classiquement par exemple lors du moulage des flancs d'isolement 10a, 10b, 10c, 10d.

De façon avantageuse, dans le cas où les extrémités de câble touchent les faces non lisses du flanc d'isolement considéré 10a, 10b, 10c, 10d, la texture non lisse limite en outre le déplacement des câbles dans le logement 6a, 6b, 6c, 6d et donc limite un risque de détachement de brins ou de glissement de brins dans le coffre du travail 5. Selon un mode de réalisation préféré, le capot 3 comporte également au moins une zone pourvue d'aspérités pour limiter un glissement des brins dans le coffre de travail 5.

Dans le cas présent, le capot 3 comporte une languette gauche 16 associée au premier logement 6a, une languette centrale 17 associée aux logements centraux 6b, 6c et une languette droite 18 associée au quatrième logement 6d, chaque languette 16, 17, 18 étant pourvue d'aspérités. Le capot 3 est tel que les languettes 16, 17, 18 s'étendent sensiblement au niveau des orifices 11a, 11b, 11c, 11d d'accès des pattes de connexion à l'intérieur du bornier 4. Bien entendu les languettes 16, 17, 18 ne gênent toutefois pas l'agencement des pattes de connexion dans les logements 6a, 6b, 6c, 6d.

Dans le cas présent, les languettes 16, 17, 18 s'étendent dans le prolongement des flancs d'isolement 10a, 10b, 10c, 10d du logement 6a, 6b, 6c, 6d associé. Plus précisément ici au moins une face de chaque languette 16, 17, 18 tournée vers l'intérieur du logement associé est pourvue d'aspérités.

De préférence, la texture non lisse pourvue d'aspérités de chaque languette 16, 17, 18 est assurée au moins par des stries.

De préférence, les languettes 16, 17, 18 sont ici entièrement gondolées de sorte que des stries recouvrent, de manière régulièrement répartie, toute la surface de leurs faces tournées vers l'intérieur des logements 6a, 6b, 6c, 6d. De préférence, les stries d'une même face striée sont juxtaposées de manière qu'il n'y a pas de zones planes entre deux stries consécutives : à un creux d'une strie succède immédiatement un sommet d'une autre.

Les stries présentent ici une section en triangle. Chaque languette 16, 17, 18 présente donc une section générale en dents de scie.

Par ailleurs les stries sont conformées de manière que le sommet libre de chaque strie forme un angle aigu et donc non arrondi.

On facilite ainsi le glissement des brins dans le creux des stries.

Les stries sont telles que la hauteur entre le sommet libre de chaque strie et la base de la strie associée soit au moins de 0.5 millimètre de hauteur et préférentiellement encore au moins de 0.8 millimètre de hauteur et préférentiellement encore au moins de 1 millimètre de hauteur.

Les stries présentent plus précisément ici une section en triangle isocèle ou équilatéral.

Selon un mode de réalisation préféré, les stries sont conformées pour s'étendre sensiblement orthogonalement au socle.

En réalité ici les stries des languettes 16, 17, 18 et celles des flancs d'isolement 10a, 10b, 10c, 10d sont identiques.

Les stries des languettes 16, 17, 18 sont par exemple décalées, en hauteur, des stries des flancs d'isolement associés.

Préférentiellement, la texture non lisse pourvue d'aspérités de chaque languette 16, 17, 18 est également assurée ici par un grainage desdites languettes 16, 17, 18.

De la sorte, on augmente les propriétés d'anti-glissement des languettes 16, 17, 18.

Le grainage recouvre ici de manière continue toute la surface des faces texturées des languettes 16, 17, 18.

Le grainage des faces pourvues d'aspérités tournées vers l'intérieur des logements 6a, 6b, 6c, 6d est par exemple tel que lesdites faces comportent des criques d'une profondeur comprise entre 3 et 5 centièmes de millimètres.

Le grainage et le striage des faces pourvues d'aspérités tournées vers l'intérieur des logements 6a, 6b, 6c, 6d eut se faire classiquement par exemple lors du moulage des languettes 16, 17, 18.

Bien entendu l'invention n'est pas limitée aux modes de réalisation décrits et on peut y apporter des variantes sans sortir du cadre de l'invention tel que défini par les revendications.

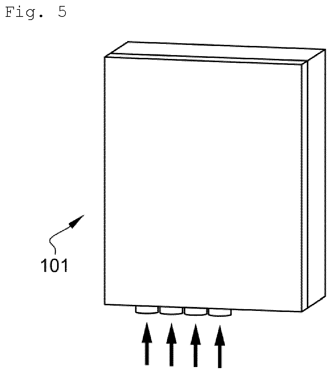

En particulier, bien qu'ici le boîtier soit un compteur électrique à entrée haute, le boîtier pourra être différent et être par exemple un compteur électrique à entrée basse tel qu'illustré à la figure5, ou de manière plus générale un boîtier électronique ou un boîtier électrique.

Le boîtier pourra ainsi être différent de ce qui a été indiqué et donc comprendre un nombre différent de logement que ce qui a été indiqué et par exemple un seul logement.

De la même manière le nombre d'ouvertures pourra être différent de ce qui a été indiqué. Le boîtier pourra par exemple comporter une seule ouverture.

Par ailleurs, bien qu'ici les ouvertures soient ménagées dans une même paroi, les ouvertures pourront être ménagées dans des parois différentes.

La texture non lisse du flanc pourra être conformée différemment de ce qui a été indiqué.

Ainsi bien qu'ici les flancs soient à la fois striés et grainés, les flancs pourront être juste striés ou juste granulés. La texture non lisse des flancs pourra être créée d'une autre manière que par des stries ou un grainage comme par exemple par un quadrillage de nervures.

Ainsi, bien qu'ici les stries s'étendent entre le capot et le socle orthogonalement au capot et au socle, les stries pourront être orientées différemment et par exemple s'étendre parallèlement au capot ou au socle ou en diagonale entre le capot et le socle. Les stries pourront également s'étendre selon plusieurs directions sur une même face striée.

Bien que les stries présentent une section en triangle, les stries pourront avoir une autre section et être par exemple conformées en carré ou en arc de cercle. On préférera toutefois avoir des stries avec une arrête pointue facilitant la retombée des brins dans le fond des stries.

D'autres surfaces du boîtier que celles indiquées pourront être pourvues d'aspérités afin de limiter encore davantage la tombée des brins dans le coffre de travail. On réalisera ces aspérités sur les surfaces les plus proches des interstices entre le bornier et le reste du boitier.

Par ailleurs la texture non lisse pourra concerner une seule face, plusieurs faces ou toutes les faces des portions du boitier concernées. On pourra par exemple avoir des flancs conformés en tôle ondulé de sorte qu'ils présenteront des stries sur leurs deux faces principales et/ou des languettes ne comportant des aspérités que sur une seule face. Par ailleurs, on pourra avoir des aspérités différentes entre deux faces d'un même élément ou des aspérités différentes.

Le boitier pourra ne pas comporter de languettes et/ou pourra ne pas comporter de languettes coopérant avec les flancs d'isolement. Le boitier pourra comporter un autre nombre de languettes que ce qui a été indiqué. De manière générale, le boitier pourra comporter une ou d'autres zones pourvues d'aspérités pour limiter un glissement de brins dans le coffre de travail que ce qui a été indiqué. Bien qu'ici les languettes s'étendent dans le prolongement du flanc d'isolement du logement associé, au moins une des languettes pourra être agencée à l'aplomb du flanc d'isolement associé.

Par ailleurs, bien qu'ici chaque languette soit décalée en hauteur vis-à-vis du flanc d'isolement associé au moins une des languettes pourra être conformée de manière qu'un creux de chacune de ses stries corresponde à un sommet des stries du flanc d'isolement associé et inversement. Les stries de la languette et celle du flanc associé seront ainsi décalés latéralement les unes des autres. De la sorte, lorsque le capot est en place sur le socle, les stries de la languette coopéreront avec les stries du flanc d'isolement associé de manière à assurer un emboîtement des stries entre elles.

## Revendications

1. Boitier comprenant un bornier (4) destiné à accueillir au moins une extrémité d'un câble multibrins et comprenant à cet effet au moins un logement (6a, 6b, 6c, 6d) de réception de l'extrémité du câble, le logement étant pourvu d'une paroi (8) dans laquelle est ménagée une ouverture (7a, 7b, 7c, 7d) à travers laquelle s'étend en service l'extrémité du câble, ledit logement étant **caractérisé en ce qu'**il est pourvu d'un flanc (10a, 10b, 10c, 10d) agencé à l'opposé de la paroi portant l'ouverture, au moins une face du flanc orientée vers l'intérieur du logement étant pourvue d'aspérités pour limiter un risque de glissement d'au moins un brin détaché de l'extrémité du câble à travers un espace entre le flanc et le reste du boitier.

2. Boitier selon la revendication 1, dans lequel des aspérités de la face sont formées au moins par des stries.

3. Boitier selon la revendication 2, dans lequel les stries sont juxtaposées sans espace entre deux stries consécutives.

4. Boitier selon l'une des revendications 2 ou 3, dans lequel les stries sont toutes identiques sur une même face.

5. Boitier selon l'une des revendications 2 à 4, dans lequel au moins l'une des stries a une section triangulaire.

6. Boitier selon l'une des revendications 2 à 5, dans laquelle au moins l'une des stries présente un sommet pointu.

7. Boitier selon l'une des revendications 2 à 6, dans lequel au moins l'une des stries a une hauteur au moins supérieure à 1 millimètre.

8. Boitier selon l'une des revendications précédentes, dans lequel des aspérités de la face sont formées au moins par un grainage de la face.

9. Boitier selon la revendication 8, dans lequel le grainage est tel qu'il forme des criques d'une profondeur comprise entre 3 et 5 centièmes de millimètres sur la face associée.

10. Boitier selon l'une des revendications précédentes, dans lequel le boitier comporte au moins une languette (16, 17, 18) agencée au niveau de l'espace entre le flanc et le reste du boitier, au moins une face de la languette étant pourvue d'aspérités.

11. Boitier selon la revendication 10, dans lequel des aspérités de la face de la languette sont formées au moins par des stries.

12. Boitier selon l'une des revendications 10 à 11, dans lequel des aspérités de la face de la languette sont formées au moins par un grainage de ladite face.

13. Boitier selon l'une des revendications précédentes, dans lequel le boitier est un compteur électrique.

## Patentansprüche

1. Gehäuse, umfassend eine Klemmenleiste (4), die dazu bestimmt ist, mindestens ein Ende eines mehrstrangigen Kabels aufzunehmen, und zu diesem Zweck mindestens eine Aufnahme (6a, 6b, 6c, 6d) zur Aufnahme des Endes des Kabels umfasst, wobei die Aufnahme mit einer Wand (8) versehen ist, in der eine Öffnung (7a, 7b, 7c, 7d) ausgebildet ist, durch die sich im Gebrauch das Ende des Kabels erstreckt, wobei die genannte Aufnahme **dadurch gekennzeichnet ist, dass** sie mit einer Flanke (10a, 10b, 10c, 10d) versehen ist, die gegenüber der die Öffnung tragenden Wand angeordnet ist, wobei mindestens eine Fläche der Flanke, die zum Inneren der Aufnahme ausgerichtet ist, mit Unebenheiten versehen ist, um das Risiko eines Gleitens mindestens eines von dem Ende des Kabels gelösten Stranges durch einen Raum zwischen der Flanke und dem Rest des Gehäuses zu begrenzen.

2. Gehäuse nach Anspruch 1, bei dem Unebenheiten der Fläche mindestens durch Riffeln gebildet sind.

3. Gehäuse nach Anspruch 2, bei dem die Riffeln nebeneinander angeordnet sind, ohne einen Raum zwischen zwei aufeinanderfolgenden Riffeln.

4. Gehäuse nach einem der Ansprüche 2 oder 3, bei dem die Riffeln auf einer selben Fläche alle identisch sind.

5. Gehäuse nach einem der Ansprüche 2 bis 4, bei dem mindestes eine der Riffeln einen dreieckigen Querschnitt hat.

6. Gehäuse nach einem der Ansprüche 2 bis 5, bei dem mindestens eine der Riffeln einen spitzen Scheitelpunkt aufweist.

7. Gehäuse nach einem der Ansprüche 2 bis 6, bei dem mindestens eine der Riffeln eine Höhe hat, die mindestens größer als ein Millimeter ist.

8. Gehäuse nach einem der vorhergehenden Ansprüche, bei dem Unebenheiten der Fläche mindestens durch eine Körnung der Fläche gebildet sind.

9. Gehäuse nach Anspruch 8, bei dem die Körnung derart ist, dass sie Risse mit einer Tiefe zwischen 3 and 5 Hundertstel Millimetern auf der dazugehörigen Fläche bildet.

10. Gehäuse nach einem der vorhergehenden Ansprüche, bei dem das Gehäuse mindestens eine Lasche (16, 17, 18) umfasst, die im Bereich des Raums zwischen der Flanke und dem Rest des Gehäuses angeordnet ist, wobei mindestens eine Fläche der Lasche mit Unebenheiten versehen ist.

11. Gehäuse nach Anspruch 10, bei dem Unebenheiten der Fläche der Lasche zumindest durch Riffeln gebildet sind.

12. Gehäuse nach einem der Ansprüche 10 bis 11, bei dem Unebenheiten der Fläche der Lasche zumindest durch eine Körnung der genannten Fläche gebildet sind.

13. Gehäuse nach einem der vorhergehenden Ansprüche, bei dem das Gehäuse ein Stromzähler ist.

## Claims

1. A unit including a terminal block (4) for receiving at least one end of a multistrand wire and comprising for this purpose at least one housing (6a, 6b, 6c, 6d) for receiving the end of the wire, the housing being provided both with a wall (8) having an opening (7a, 7b, 7c, 7d) made therein through which the end of the wire extends in service, said housing being **characterized in that** it being provided with a flank (10a, 10b, 10c, 10d) arranged opposite from the wall that includes the opening, at least one face of the flank facing towards the inside of the housing being provided with asperities in order to limit any risk of a strand detached from the end of the wire sliding through space between the flank and the remainder of the unit.

2. A unit according to claim 1, wherein asperities of the face are formed at least by serrations.

3. A unit according to claim 2, wherein the serrations are juxtaposed without space between two consecutive serrations.

4. A unit according to claim 2 or claim 3, wherein the serrations on a given face are all identical.

5. A unit according to any one of claims 2 to 4, wherein at least one of the serrations is triangular in section.

6. A unit according to any one of claims 2 to 5, wherein at least one serration presents a sharp top.

7. A unit according to any one of claims 2 to 6, wherein at least one of the serrations has a height at least superior to 1 mm.

8. A unit according to any preceding claim, wherein asperities of the face are formed at least by roughening the face.

9. A unit according to claim 8, wherein the roughening is such that it forms cracks having a depth lying in the range 3 to 5 hundredths of a millimeter in the associated face.

10. A unit according to any preceding claim, wherein the unit includes at least one tongue (16, 17, 18) arranged in the space between the flank and the remainder of the unit, at least one face of the tongue being provided with asperities.

11. A unit according to claim 10, wherein asperities of the face of the tongue are formed at least by serrations.

12. A unit according to claim 10 to claim 11, wherein asperities of the face of the tongue are formed at least by roughening said face.

13. A unit according to any preceding claim, wherein the unit is an electricity meter.
